# EUROPEAN PATENT APPLICATION

(11) **EP 2 390 685 A1**
(43) Date of publication of application: **30.11.2011**
(21) Application number: 10750625.5
(22) Date of filing: 18.01.2010
(51) Int. Cl.: G02B 3/00, C30B 29/20, C30B 33/02, G02B 1/02

(54) **METHOD FOR MANUFACTURING SINGLE CRYSTAL OPTICAL LENS**

(30) Priority: 09.03.2009 JP 2009054961
(71) Applicant: OLYMPUS MEDICAL SYSTEMS CORP., Tokyo 151-0072 (JP); OLYMPUS CORPORATION, Shibuya-ku Tokyo 151-0072 (JP)
(72) Inventor: KINOSHITA, Hiroaki, Tokyo 151-0072 (JP); MORITA, Yuko, Tokyo 151-0072 (JP)
(74) Representative: Gunzelmann, Rainer
(86) International application number: PCT/JP2010/050857
(87) International publication number: WO 2010/103869

(57) **Abstract**

The invention provides a fabrication process for single-crystal optical lenses wherein, in a processing step for a single-crystal lens, at least one heating treatment is implemented after a member is cut out of a single-crystal matrix material having a melting point of greater than 2,000°C to less than 2,900°C and before a lens assembling step. In this case, the heating treatment is preferably implemented at a temperature that is 0.50 times to 0.67 times as high as the melting point.

## Description

### ART FIELD

The present invention relates generally to a fabrication process for single-crystal optical lenses, and more particularly to a fabrication process for single-crystal optical lenses used on a variety of optical products.

### BACKGROUND ART

Single-crystal materials capable of transmitting visible light, such as crystal quartz, sapphire and fluorite (calcium fluoride), have been used as materials for optical lenses and optical filters. These crystal materials have been used for lens parts demanded to have properties not found in optical glasses because of having optical characteristics (refractive index, Abbe constant and transmittance), hardness, chemical robustness, heat resistances which the optical glasses do not possess. In the fabrication process for optical lenses, optical filters, etc., a member cut out of the starting single-crystal matrix material is ground and polished to the desired shape in such a way as to have a finished-up surface, after which abrasives and polishing solutions are removed off. Then, that member is coated as required, and assembled into an optical product. Often, the rim surface of a lens is preferably roughened for the purpose of preventing reflection of inessential light when it is incorporated in the optical product. However, there is a problem that many cracks tend to occur from the rim portion of the lens because the rim surface is in a roughened state.

Cracks from the rim surface occur in severing, cutting and polishing steps as well as in a centering step of configuring a lens contour in alignment with the optical axis of a lens after the formation of lens surfaces and in an assembling step of setting a lens part in a lens barrel. Those cracks may develop upon mechanical shocks and thermal shocks applied to it during use after incorporated in an optical product. There are thus means in demand that can stave off cracks detrimental to product reliability.

By the way, sapphire single-crystal materials have also been used as a substrate material for epitaxial growth of nitride semiconductor thin films, dielectric thin films, etc. In this case, much more reduced crystal defects are requisites for making thin-film structure uniform, and various methods have been proposed so as to reduce or eliminate crystal defects.

Patent Publication 1 sets forth a process wherein a sapphire single-crystal ingot is ground, and then subjected to chemical polishing at its rim portion before wafers are sliced out. With that process, distortion upon processing and minute cracks at the rim portion of the sapphire ingot are removed off thereby preventing a substrate from cracking that otherwise occurs upon epitaxial growth of a nitride semiconductor.

For chemical polishing, however, there is the need of sorting out a proper chemical solution depending on the type of crystal materials. Although depending on chemical solution/material combinations, there are problems occurring such as glaring of the rim portion due to an etching rate difference due to crystal orientation. Chemical polishing also requires the use of heated acids that may offer hazards to working environments.
Patent Publication 1: JP(A) 2005-255463

### DISCLOSURE OF THE INVENTION

Having been made in view of such problems with the prior art as mentioned above, the present invention has for its object to provide a fabrication process for single-crystal lenses which prevents cracks from occurring from the rim surface of a lens.

In order to accomplish the aforesaid object, the present invention is embodied as follows.
(1) A fabrication process for single-crystal optical lenses, **characterized in that** in a processing step for a single-crystal lens, at least one heating treatment is implemented after a member is cut out of a single-crystal matrix material having a melting point of greater than 2,000°C to less than 2,900°C and before a lens assembling step.

(2) The fabrication process for single-crystal optical lenses according to (1) above, **characterized in that** said heating treatment is implemented at a temperature that is 0.50 times to 0.67 times as high as the melting point.

(3) The fabrication process for single-crystal optical lenses according to (1) above, **characterized in that** in a processing step for a crystal lens comprising a crystal material, a member having a rim surface defining a lens contour is heated and then severed to a given thickness, after which lens surfaces are processed to obtain a crystal lens.

(4) The fabrication process for single-crystal optical lenses according to (1) above, **characterized in that** in a processing step for a crystal lens comprising a crystal material, heating treatment is implemented after polishing of lens surfaces and grinding of a rim of the lens.

(5) The fabrication process for single-crystal optical lenses according to (1) above, **characterized in that** said crystal material is sapphire.

The aforesaid (1) to (5) are now explained. Explanation of (1)
When the crystal material is severed, processed or rounded so as to configure it into a given shape, minute cracks and distortion of crystal structure come about at cut surfaces by reason of shocks upon processing. Distortion of crystal structure brings about both tensile stress and compressive stress near the cut surfaces. Given stress already existing in the material, thresholds of force that develops minute cracks vary even with the same force applied to it. In other words, minute cracks at a site where tensile stress works are more likely to develop than those at a stress-free site.

With the inventive process, stress ascribable to distortion of crystal structure brought about by shocks can be removed off by heating treatment. Even though external force by the next processing is applied here, cracks from the rim portion will be less likely to develop because the stress is already removed off by the heating treatment.

The crystal material used here includes single-crystal materials having a melting point of greater than 2,000°C to less than 2,900°C for instance, sapphire, yttria-stabilized zirconia, yttrium oxide, zirconium oxide, and magnesium oxide.

These high-melting crystal materials work in favor of letting optical devices have wide angles of view and making them compact because of having a refractive index so high that refraction of light at lens surfaces can grow large. On the other hand, however, the smaller the lens, the smaller the difference between the effective diameter of the lens (a lens area where light rays pass) and the lens contour becomes, ending up with minimization of tolerance size for cracks from the lens rim portion. As compared with general optical glasses, the crystal materials are more susceptible of crack development by shocks upon processing, and more likely to cleave and crack, because of their cleavage capability inherent in crystals. This is the reason the inventive process takes effects.

Heating may be achieved by various methods using an electric furnace, a gas furnace, and a laser annealing furnace. The heating atmosphere applied may be properly selected in consideration of the type of crystal material, furnace material, and holder material in a heating furnace. The aforesaid oxide crystal may be heated in the atmosphere without relying upon any special atmosphere gas; however, when it is necessary to prevent oxidation of the holder member or the like, heating may be implemented in a vacuum or nitrogen, argon or other inert gas atmospheres.

During the heating treatment, it is desired to avoid rapid heating or cooling for the purpose of getting around crack development by thermal shocks.

### Explanation of (2)

As for crystal materials, it has been known that crystal defects such as dislocation can be reduced by heating them in a temperature region near the melting points. However, heating the aforesaid high-melting crystal materials at a temperature near their melting points does not only require a furnace resistant to high temperatures in hand, but is also impractical in view of energy consumption taken for the introduction of it in the lens processing step.

The present invention is most effective when the heating temperature is 0.50 times to 0.67 times as high as the melting point (Kelvin temperature). At less than 0.50, the effect on distortion removal becomes insufficient because the energy involved is insufficient. At greater than 0.67, the effect on distortion removal remains sufficient, but there are inconveniences in such high temperature regions, for instance, enlargement of dislocations probably due to slippage of dislocations within crystals, and roughening of substrate surfaces during heating. This further leads to problems that post-processing lens surfaces deteriorate in terms of figure tolerance (surface precision).

### Explanation of (3)

In the processing step for crystal lenses, a rod or block member having a rim surface that defines the contour of a lens is severed and polished into a crystal lens. If the rod or block member having a rim surface that defines the contour of the lens is heated, it is then possible to prevent cracking of the rim portion.

The rim portion of the member having a rim surface that defines the contour of the lens may be of various shapes inclusive of circles, polygonal pyramids, eclipses, semicircles comprising arcs and straight lines: it may have any desired shape depending on the contour of the lens. The rim portion shape may partly include the final contour of the lens.

The lens surfaces may be processed into planar, convex or concave shapes. The lens surfaces may also be of roughened rather than mirror-finished shapes.

### Explanation of (4)

In the processing step for crystal lenses, lens surfaces are polished and cut to process the rim of the lens, and then heated, after which they are passed over into the assembling step. By doing so, it is possible to reduce or eliminate crack developments due to mechanical shocks upon assembling and thermal shocks at a soldering or otherwise sealing step.

At the same time, it is possible to reduce or eliminate cracks in the product due to shocks during use, thereby improving the reliability of the product.

### Explanation of (5)

Of single-crystal materials, a sapphire single-crystal material undergoes large force during cutting and rounding because of its high hardness. It has now been found that near the site to be processed, distortion of crystal structure caused by shocks applied upon cutting remains significantly, resulting in buildups of tensile stress near cracks and bringing about crack developments at the next step.

Sapphire is a crystal material having a melting point as high as 2,035°C With the inventive process, however, heating is implemented at a temperature of about 880°C to about 1,270°C preferably about 1,000°C to about 1,270°C so that lenses can be prevented from cracking during processing. Further, alumina or other general materials may be used for furnaces, holders for lenses during heating, etc. In this respect, too, the present invention is practical.

In accordance with the present invention, it is possible to fabricate single-crystal lenses in higher yields, which are prevented from cracking from their rim surfaces during fabrication or when optical products comprising them are being used.

### BEST MODE FOR CARRYING OUT THE INVENTION

The inventive fabrication process for optical lenses is now explained with reference to specific examples.

### Example 1

A sapphire single-crystal cylindrical rod (3 mm in diameter and 50 mm in length; sand-polished rim surface) was annealed for 5 hours at the maximum temperatures of 800°C, 900°C, 1,000°C, 1,100°C, 1,200°C, 1,300°C, and 1,400°C, respectively. This rod member was severed to a thickness of 1 mm, ground and plane-polished into a double-plano lens. The defectives rates caused by cracks from the rim portion were 30%, 0.5%, 0%, 0%, 0%, 0%, and 0% in order . Heating at 1,300°C, and 1,400°C gave rise to figure tolerance deterioration.

Whether or not there were cracks from the rim, and whether figure tolerance was high or low in this example was inspected, with the results set out in Table 1 below. The symbol ○ indicates that there is no crack with high figure tolerance, and X indicates that there are cracks with low figure tolerance.

**Table 1**

| Heating Temp. | 800°C | 900°C | 1,000°C | 1,100°C |
|---|---|---|---|---|
| Cracks from the rim | X | ○ | ○ | ○ |
| Figure Tolerance | ○ | ○ | ○ | ○ |
| Heating Temp. | 1, 200°C | 1,300°C | 1,400°C | |
| Cracks from the rim | ○ | ○ | ○ | |
| Figure Tolerance | ○ | X | X | |

### Comparative Example 1

The same sapphire cylindrical rod as in Example 1 was processed as in Example 1 except that it was not annealed. The defectives rate was 50% in terms of cracks from the rim portion.

### Example 2

A rod member of 2 mm in diameter was cut out of a sapphire single-crystal material, and then severed to 1 mm. Then, that rod member was processed into a plano-concave lens through the grinding and polishing steps. For centering, the lens was cut off at the rim portion, and heated at the temperatures set out in Table 2 below. The heating rate was 0.8°C/min., and the cooling rate was 1°C/min. Post-polishing lens figure tolerance, and post-heating figure tolerance was measured and inspected by means of an interferometer. Then, the sides of the post-heating lens were metalized, and fixed to and sealed in a lens barrel by soldering. Then, whether or not there were lens cracks, and whether figure tolerance was high or low was inspected with the results set out in Table 2.

**Table 2**

| Heating Temp. | 800°C | 900°C | 1,000°C | 1,100°C |
|---|---|---|---|---|
| Cracks | X | ○ | ○ | ○ |
| Figure Tolerance | ○ | ○ | ○ | ○ |
| Heating Temp. | 1,200°C | 1,300°C | 1,400°C | |
| Cracks | ○ | ○ | ○ | |
| Figure Tolerance | O | X | X | |

### Comparative Example 2

The rod member was fixed to and sealed in a lens barrel by the same method as in Example 2 with the exception that no heating was implemented after centering, and whether or not there were lens cracks was inspected. Consequently, about 30% of the lenses were found to have cracks in them.

### Example 3

A rod member of 4 mm in diameter was cut out of a sapphire single-crystal material, and then subjected to the first heating treatment at 1,000°C for 2 hours. Thereafter, that rod member was severed in a longitudinal direction into another rod member of a half moon shape in section, which was in turn subjected to the second heating treatment at 1,000°C for 2 hours. Thereafter, the rod member was severed to 0.9 mm and plane ground on both its sides into a double-plano lens.

The defectives rates in this example, and the defectives rates in the cases where heating was not implemented at all, and the first heating treatment alone was applied for the purpose of comparisons are set out in Table 3 below.

**Table 3**

| Heating Treatment | No Heating | First Heating Alone | First Heating plus Second heating |
|---|---|---|---|
| Defectives Rate for cracks at the rim portion | 40% | 18% | 0% |

While the inventive fabrication process for optical lenses has been explained with reference to inventive and comparative examples, it is to be understood that the present invention is by no means limited to them: it may be modified in various ways.

### INDUSTRIAL APPLICABILITY

In accordance with the present invention, it is possible to fabricate single-crystal lenses in higher yields, which are prevented from cracking from their rim surfaces during fabrication or when optical products comprising them are being used.

## Claims

1. A fabrication process for single-crystal optical lenses, **characterized in that** in a processing step for a single-crystal lens, at least one heating treatment is implemented after a member is cut out of a single-crystal matrix material having a melting point of greater than 2,000°C to less than 2,900°C and before a lens assembling step.

2. The fabrication process for single-crystal optical lenses according to claim 1, **characterized in that** said heating treatment is implemented at a temperature that is 0.50 times to 0.67 times as high as the melting point.

3. The fabrication process for single-crystal optical lenses according to claim 1, **characterized in that** in a processing step for a crystal lens comprising a crystal material, a member having a rim surface defining a lens contour is heated and then severed to a given thickness, after which lens surfaces are processed to obtain a crystal lens.

4. The fabrication process for single-crystal optical lenses according to claim 1, **characterized in that** in a processing step for a crystal lens comprising a crystal material, heating treatment is implemented after polishing of lens surfaces and grinding of a rim of the lens.

5. The fabrication process for single-crystal optical lenses according to claim 1, **characterized in that** said crystal material is sapphire.
